# EUROPEAN PATENT APPLICATION

(11) **EP 1 753 020 A1**
(43) Date of publication of application: **14.02.2007**
(21) Application number: 05740993.0
(22) Date of filing: 20.05.2005
(51) Int. Cl.: H01L 21/3205, C23C 14/16, H01L 21/768

(54) **SEMICONDUCTOR DEVICE AND METHOD FOR FABRICATING THE SAME**

(30) Priority: 03.06.2004 JP 2004165360
(71) Applicant: MATSUSHITA ELECTRIC INDUSTRIAL CO., LTD., Kadoma-shi, Osaka 571-8501 (JP)
(72) Inventor: IKEDA, Atsushi, c/o Matsushita Elec. Ind. Co., Ltd, Chuo-ku, Osaka 540-6319 (JP); NAKAGAWA, Hideo, c/o Matsushita Elec. Ind. Co.,Ltd, Chuo-ku, Osaka 540-6319 (JP); AOI, Nobuo, c/o Matsushita Elec. Ind. Co., Ltd., Chuo-ku, Osaka 540-6319 (JP)
(74) Representative: Grünecker, Kinkeldey, Stockmair & Schwanhäusser Anwaltssozietät
(86) International application number: PCT/JP2005/009265
(87) International publication number: WO 2005/119750

(57) **Abstract**

A semiconductor device includes an insulation film **6** formed on a silicon substrate **1,** a buried interconnect **10** formed in the insulation film **6,** and a barrier metal film **A1** formed between the insulation film **6** and the buried interconnect **10.** The barrier metal film **A1** is formed of a lamination layer of a metal compound film **7** and a metal film **9** which does not loose its conductivity when being oxidized. In the vicinity of an interface between the metal compound film **7** and the metal film **9,** a fusion layer **8** obtained through fusion of the metal compound film **7** and the metal film 9 is provided.

## Description

### TECHNICAL FIELD

The present invention relates to a semiconductor device including a metal interconnect and a method for fabricating the semiconductor device, and more particularly relates to a barrier metal film and a method for forming the barrier metal film.

### BACKGROUND ART

In recent years, as the feature size of semiconductor integrated circuit devices (which will be hereafter referred to as "semiconductor devices") becomes smaller, a combination of a copper interconnect and an insulation film having a low dielectric constant, i.e., a so-called low-k film has been adopted as a multi-layer interconnect of a semiconductor device. With use of such a multi-layer interconnect, RC delay and power consumption can be reduced. Furthermore, to increase the degree of integration, function and operation speed of a semiconductor device, use of a low-k film having an even lower dielectric constant than that of those presently used is examined.

A copper interconnect is usually formed using a damascene technique. Damascene techniques include a single damascene technique in which an interconnect and a via plug are alternately formed and a dual damascene technique in which an interconnect and a via plug are simultaneously formed.

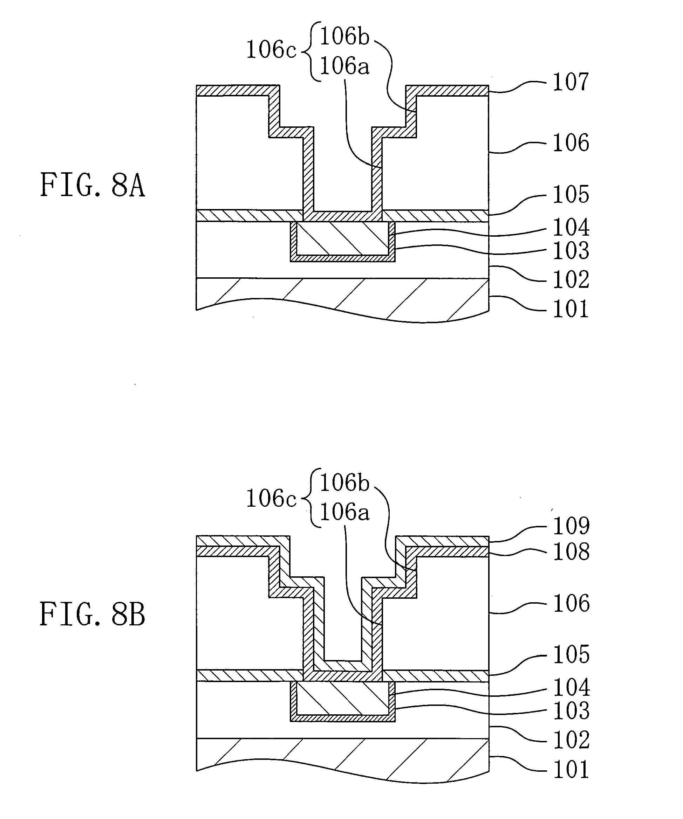

Hereinafter, a method for forming a multi-layer interconnect by a damascene technique will be described with reference to FIGS. **8(a)** and **8(b).**

As shown in FIG. **8(a),** a first insulation film **102** is formed on a silicon substrate **101** and then a first copper interconnect **104** including a first barrier metal film **103** is formed in the first insulation film **102.** On the silicon substrate **101,** a transistor and the like (not shown) are formed. Subsequently, a dielectric barrier film **105** for preventing diffusion of copper and a second insulation film **106** are formed in this order over the first insulation film **102** and the first copper interconnect **104.** Then, a via hole **106a** is formed in the dielectric barrier film **105** and the second insulation film **106** and an interconnect trench **106b** is formed in the second insulation film **106.** Thus, a recess portion **106c** including the via hole **106a** and the interconnect trench **106b** is obtained. Next, a second barrier metal film **107** is formed so as to cover surfaces of the recess portion **106c.** In FIG. **8(a),** the case where as a barrier metal structure of an upper layer, a single layer structure of the second barrier metal film **107** is used is shown. However, as shown in FIG. **8(b),** a two-layer structure of the second barrier metal film **108** and the third barrier metal film **109** may be provided so as to cover the surfaces of the recess portion **106c.**

Next, although not shown in the drawings, in the case shown in FIG. 8(a), a copper film is formed on the second barrier metal film **107** (the third barrier metal film **109** in the case of shown in FIG. **8(b))** and then a copper film is formed by copper electroplating using the copper seed layer as a seed so as to fill the recess portion **106c** and entirely cover the surfaces of the second insulation film **106.** Subsequently, in the case shown in FIG. **8(a),** part of the copper film located on the second insulation film **106,** except for part of the copper film located inside of the recess portion **106c,** (or in the case shown in FIG. **8(b),** parts of the third barrier metal film **109** and the second barrier metal film **108** located on the second insulation film **106,** except for parts of the third barrier metal film **109** and the second barrier metal film 108 located inside of the recess portion **106c)** is removed by polishing using chemical mechanical polishing (CMP). Thus, an interconnect, a via plug, or both of an interconnect and a via plug can be formed. A multi-layer interconnect can be formed by repeating a series of process steps described above.

In general, copper is easily diffused in an insulation film such as silicon oxide film by heat or an electric field. This tends to be a cause of deterioration of transistor characteristics. Also, copper has poor adhesion with an insulation film. Therefore, a method in which in forming a copper interconnect, a barrier metal film of a tantalum film or a tantalum nitride film is formed between copper and an insulation film to prevent diffusion of copper into an insulation film and improve adhesion between the insulation film and copper has been proposed. For example, when the barrier metal film has a single-layer structure of a tantalum film or a tantalum nitride film, the structure shown in FIG. **8(a)** is formed, and when the barrier metal film has a two-layer structure of a tantalum film and a tantalum nitride film, the structure shown in FIG. **8(b)** is formed.

However, when a tantalum film is used as the second barrier metal film **107** (in the case shown in FIG. **8(a))** or the third barrier metal film **109** (in the case shown in FIG. 8(b)), the tantalum film is oxidized in forming copper by electroplating, so that a high resistance tantalum oxide film is formed. Because of this, increase in interconnect resistance can not be avoided. When a tantalum nitride film is used as the second barrier metal film **107** (in the case shown in FIG. **8(a))** or the third barrier metal film **109** (in the case shown in FIG. **8(b)),** the tantalum nitride film is not oxidized but has a high resistance and poor adhesion with copper. Furthermore, when a titanium film or a titanium nitride film is used as the second barrier metal film **107** (in the case shown in FIG. **8(a))** or the third barrier metal film **109** (in the case shown in FIG. **8(b)),** the same problem arises as when a tantalum film or a tantalum nitride film is used.

In view of the above-described problems, a metal such as ruthenium and iridium which itself or whose oxide has a low resistance is used as the second barrier metal film 107 to achieve reduction in resistance of the second barrier metal film 107 (see, for example, Patent Reference 1 and Patent Reference 2), and this technique has attracted interest. In general, such metals are formed by atomic layer deposition or chemical vapor deposition.
(Patent Reference 1) Japanese Patent Publication No. 3409831
(Patent Reference 2) Japanese Laid-Open Publication No. 2002-75994

### DISCLOSURE OF INVENTION

### Problems that the invention is to solve

As has been described, when a metal, such as ruthenium and iridium, which does not loose its conductivity when being oxidized is used as a barrier metal film, the barrier metal film can be formed to have a low resistance. A metal which does not loose its conductivity has very poor adhesion with an insulation film. As a method for solving such a problem, a metal nitride film or the like, or a lamination film including the metal nitride film is formed between a barrier metal film made of such a metal which does not loose its conductivity and an insulation film, thereby improving adhesion between the barrier metal film and the insulation film. However, another problem arises. That is, adhesion of a metal film which does not loose its conductivity when being oxidized with a metal nitride film or a lamination film including the metal nitride film or the like becomes poor.

In view of the above-described problems, it is an object of the present invention to provide a semiconductor device including a barrier metal film with a low resistance and excellent adhesion with an insulation film and an interconnect and a method for fabricating the semiconductor device.

### Means of solving the problems

To achieve the above-described object, a semiconductor device according to the present invention is characterized in that the semiconductor device includes: an insulation film formed on a substrate; a buried interconnect formed in the insulation film; and a barrier metal film formed between the insulation film and the buried interconnect, and in the semiconductor device, the barrier metal film is formed of a lamination film of a metal compound film and a metal film which does not loose its conductivity when being oxidized, and a fusion layer obtained through fusion of the metal compound film and the metal film with each other is present in the vicinity of an interface between the metal compound film and the metal film.

In the semiconductor device of the present invention, the fusion layer is formed in the vicinity of an interface between the metal compound film and the metal film so as to extend from the interface and has an approximately intermediate composition between the films. Thus, compared to the case where the metal compound film and the metal film are merely stacked, adhesion between the metal compound film (metal oxide film) and the metal film is excellent. Therefore, a highly reliable semiconductor device including a multi-layer interconnect with a low resistance and excellent adhesion can be achieved. Moreover, adhesion with an insulation film can be improved and electroplating for forming an excellent interconnect becomes possible.

In the semiconductor device of the present invention, it is preferable that a metal forming the metal compound film and a metal forming the metal film are different elements from each other.

Thus, the fusion layer which is an alloy layer formed in the vicinity of the interface between the metal compound film and the metal film so as to extend from the interface and having an approximately intermediate composition between the films is provided. Accordingly, compared to the case where the metal compound film and the metal film are merely stacked, adhesion between the metal compound film and the metal film is excellent. Therefore, a highly reliable semiconductor device including a multi-layer interconnect with a low resistance and excellent adhesion can be achieved.

In the semiconductor device of the present invention, it is preferable that a metal forming the metal compound film and a metal forming the metal film are the same element.

Thus, the fusion layer which is a mixing layer formed in the vicinity of the interface between the metal compound film and the metal film so as to extend from the interface and having an approximately intermediate composition between the films is provided. Accordingly, compared to the case where the metal compound film and the metal film are merely stacked, adhesion between the metal compound film and the metal film is excellent. Moreover, the metal compound film and the metal film are united as one with the mixing layer interposed therebetween, so that excellent adhesion between the compound film and the metal film can be achieved, compared to the case where metals forming the films, respectively, are different from each other. Therefore, a highly reliable semiconductor device including a multi-layer interconnect with a low resistance and excellent adhesion can be achieved.

In the semiconductor device of the present invention, it is preferable that the fusion layer includes at least several atomic layers.

Thus, the fusion layer is formed at an entire face at which the metal compound film and the metal film are in contact with each other, so that adhesion between the metal compound film and the metal film is remarkably improved. Therefore, a highly reliable semiconductor device including a multi-layer interconnect with a low resistance and excellent adhesion can be achieved.

In the semiconductor device of the present invention, it is preferable that the metal compound film is formed so as to be jointed with the insulation film, and the metal film is formed on the metal compound film.

Thus, the metal film having a smaller resistance than that of the metal compound film serves as an electrode and an underlying layer in electroplating for interconnect. Accordingly, compared to the case where electroplating for interconnect is performed to a surface of the metal compound, uniform electroplating for interconnect becomes possible. Moreover, the metal film is formed of a metal which does not loose its conductivity. Therefore, when a surface of the metal film is oxidized in electroplating for interconnect, a conductivity of the metal film is not reduced and high-performance electroplating for interconnect can be achieved. Moreover, the metal compound film and the insulation film are jointed with each other. Accordingly, compared to the case where the metal film and the insulation film are jointed with each other, far more excellent adhesion can be achieved. Moreover, excellent adhesion can be achieved at an interface between adjacent two of the insulation film, the metal compound film, the fusion layer, the metal film and the interconnect formed in this order. Accordingly, overall adhesion is largely improved. Therefore, a highly reliable semiconductor device including a multi-layer interconnect with a low resistance and excellent adhesion can be achieved.

In the semiconductor device of the present invention, it is preferable that a metal forming the metal compound film is a refractory metal.

Thus, in the step of forming an interconnect in an upper layer after formation of the buried interconnect, even when heat of about 400 °C is applied, metamorphism of the metal oxide film can be prevented. Therefore, a highly reliable semiconductor device can be achieved.

In the semiconductor device of the present invention, it is preferable that the metal compound film has conductivity.

Thus, not only adhesion between the metal compound film and the metal film can be increased but also a low resistant barrier metal film can be achieved. Therefore, a highly reliable semiconductor device including a multi-layer interconnect with a low resistance and excellent adhesion can be achieved.

In the semiconductor device of the present invention, it is preferable that the metal compound film is formed of a metal oxide film.

Thus, specifically, when an upper surface of the insulation film is formed of a silicon oxide film, adhesion between the metal compound film and the insulation film can be further increased. Therefore, a highly reliable semiconductor device including a multi-layer interconnect with excellent adhesion can be achieved.

In the semiconductor device of the present invention, it is preferable that the metal compound film is formed of a metal nitride film.

Thus, specifically, when an upper surface of the insulation film is formed of a silicon nitride film, adhesion between the metal compound film and the insulation film can be further increased. Therefore, a highly reliable semiconductor device including a multi-layer interconnect with excellent adhesion can be achieved.

In the semiconductor device of the present invention, it is preferable that the metal compound film is formed of a metal carbide film.

Thus, specifically, when an upper surface of the insulation film is formed of a silicon carbide film or an organic film, adhesion between the metal compound film and the insulation film can be further increased. Therefore, a highly reliable semiconductor device including a multi-layer interconnect with excellent adhesion can be achieved.

In the semiconductor device of the present invention, the metal compound film is formed of a metal silicide film.

Thus, specifically, when an upper surface of the insulation film is formed of an insulation film containing silicon, adhesion between the metal compound film and the insulation film can be further increased. Therefore, a highly reliable semiconductor device including a multi-layer interconnect with excellent adhesion can be achieved.

In the semiconductor device of the present invention, it is preferable that the buried interconnect is formed of copper or a copper alloy.

To achieve the above-described object, a method for fabricating a semiconductor device according to the present invention is characterized in that the method includes the steps of: forming a recess portion in an insulation film provided on a substrate; forming a barrier metal film so that the barrier metal film covers surfaces of the recess portion; and forming a buried interconnect on the barrier metal film so that the recess portion is filled, and the step of forming a barrier metal film includes the step of forming a metal compound film so that the metal compound film covers surfaces of the recess portion and then forming on the metal compound film by physical vapor deposition a metal film which does not loose its conductivity when being oxidized.

According to the method for fabricating a semiconductor device according to the present invention, a metal compound film is formed and then a metal film is formed by physical vapor deposition. Thus, in formation of the metal film, electrically neutral metal particles and metal particle ions enter a surface of the metal compound film at high speed (with high energy) and a fusion layer is formed in the vicinity of an interface between the metal compound film and the metal film so as to extend from the interface and has an approximately intermediate composition between the films. Accordingly, compared to the case where the metal compound film and the metal are merely stacked, adhesion between the metal compound film and the metal film can be remarkably improved. Therefore, a highly reliable semiconductor device including a multi-layer interconnect with a low resistance and excellent adhesion can be achieved.

Moreover, according to the method for fabricating a semiconductor device according to the present invention, the metal compound film is formed so as to be jointed with the insulation film and the metal film is formed on the metal compound film. Thus, the metal film having a smaller resistance than that of the metal compound film serves as an electrode and an underlying layer in electroplating for interconnect. Accordingly, compared to the case where electroplating for interconnect is performed to a surface of the metal compound film, uniform electroplating for interconnect becomes possible. Moreover, the metal film is formed of a metal which does not loose its conductivity. Therefore, when a surface of the metal film is oxidized in electroplating for interconnect, a conductivity of the metal film is not reduced and high performance electroplating for interconnect can be achieved. Moreover, the metal compound film and the insulation film are jointed with each other. Accordingly, compared to the case where the metal film and the insulation film are jointed with each other, far more excellent adhesion can be achieved. Moreover, excellent adhesion can be achieved at an interface between adjacent two of the insulation film, the metal compound film, the fusion layer, the metal film and the interconnect formed in this order. Accordingly, overall adhesion is largely improved. Therefore, a highly reliable semiconductor device including a multi-layer interconnect with a low resistance and excellent adhesion can be achieved.

In the method for fabricating a semiconductor device according to the present invention, it is preferable that the method further includes, between the step of forming a barrier metal film and the step of forming a buried interconnect, the step of forming a seed layer on the barrier metal film, and in the step of forming a buried interconnect, the buried interconnect is formed on the seed layer so that the buried interconnect fills the recess portion.

Thus, a process window for electroplating for interconnect is enlarged. Accordingly, compared to the case where the seed layer is not formed, the step of forming the buried interconnect can be optimized in a simple manner. Therefore, a fabrication yield can be improved and also a highly reliable semiconductor device including a multi-layer interconnect with a low resistance and excellent adhesion can be stably fabricated.

In the method for fabricating a semiconductor device according to the present invention, it is preferable that a metal forming the metal compound film and a metal forming the metal film are different elements from each other.

Thus, the fusion layer which is an alloy layer formed in the vicinity of the interface between the metal compound film and the metal film so as to extend from the interface and having an approximately intermediate composition between the films is provided. Accordingly, compared to the case where the metal compound film and the metal film are merely stacked, adhesion between the metal compound film and the metal film can be remarkably improved. Therefore, a highly reliable semiconductor device including a multi-layer interconnect with a low resistance and excellent adhesion can be achieved.

In the method for fabricating a semiconductor device according to the present invention, it is preferable that a metal forming the metal compound film and a metal forming the metal film are the same element.

Thus, the fusion layer which is a mixing layer formed in the vicinity of the interface between the metal compound film and the metal film so as to extend from the interface and having an approximately intermediate composition between the films is provided. Accordingly, compared to the case where the metal compound film and the metal film are merely stacked, adhesion between the metal compound film and the metal film can be remarkably improved. Moreover, the metal compound film and the metal film are united as one with the mixing layer interposed therebetween, adhesion between the compound film and the metal film can be further improved, compared to the case where metals forming the films, respectively, are different from each other. Therefore, a highly reliable semiconductor device including a multi-layer interconnect with a low resistance and excellent adhesion can be achieved.

In the method for fabricating a semiconductor device according to the present invention, it is preferable that a fusion layer obtained through fusion of the metal compound film and the metal film with each other is formed in the vicinity of an interface between the metal compound film and the metal film, and the fusion layer includes at least several atomic layers.

Thus, the fusion layer can be formed at an entire face at which the metal compound film and the metal film are in contact with each other, so that adhesion between the metal compound film and the metal film can be remarkably improved. Therefore, a highly reliable semiconductor device including a multi-layer interconnect with a low resistance and excellent adhesion can be fabricated.

In the method for fabricating a semiconductor device according to the present invention, it is preferable that a metal forming the metal compound film is a refractory metal.

Thus, in the step of forming an interconnect in an upper layer after formation of the buried interconnect, even when heat of about 400 °C is applied, metamorphism of the metal oxide film can be prevented. Therefore, a highly reliable semiconductor device can be achieved.

In the method for fabricating a semiconductor device according to the present invention, it is preferable that the metal compound film has conductivity.

Thus, not only adhesion between the metal compound film and the metal film can be increased but also a low resistant barrier metal film can be achieved. Therefore, a highly reliable semiconductor device including a multi-layer interconnect with a low resistance and excellent adhesion can be achieved.

In the method for fabricating a semiconductor device according to the present invention, it is preferable that the metal compound film is formed of a metal oxide film.

Thus, specifically, when an upper surface of the insulation film is formed of a silicon oxide film, adhesion between the metal compound film and the insulation film can be further increased. Therefore, a highly reliable semiconductor device including a multi-layer interconnect with excellent adhesion can be achieved.

In the method for fabricating a semiconductor device according to the present invention, it is preferable that the metal compound film is formed of a metal nitride film.

Thus, specifically, when an upper surface of the insulation film is formed of a silicon nitride film, adhesion between the metal compound film and the insulation film can be further increased. Therefore, a highly reliable semiconductor device including a multi-layer interconnect with excellent adhesion can be achieved.

In the semiconductor device for fabricating a semiconductor device according to the present invention, it is preferable that the metal compound film is formed of a metal carbide film.

Thus, specifically, when an upper surface of the insulation film is formed of a silicon carbide film or an organic film, adhesion between the metal compound film and the insulation film can be further increased. Therefore, a highly reliable semiconductor device including a multi-layer interconnect with excellent adhesion can be achieved.

In the method for fabricating a semiconductor device according to the present invention, it is preferable that the metal compound film is a metal silicide film.

Thus, specifically, when an upper surface of the insulation film is formed of an insulation film containing silicon, adhesion between the metal compound film and the insulation film can be further increased. Therefore, a highly reliable semiconductor device including a multi-layer interconnect with excellent adhesion can be achieved.

In the semiconductor device for fabricating a semiconductor device according to the present invention, the buried interconnect is formed of copper or a copper alloy.

### Effects of the invention

In a semiconductor device according to the present invention, a fusion layer is formed in the vicinity of an interface between a metal compound film and a metal film so as to extend from the interface, and the fusion layer has an approximately intermediate composition between those of the metal compound film and the metal film. Thus, compared to the case where the metal compound film and the metal film are merely stacked, adhesion between the metal compound film (metal oxide film) and the metal film is excellent. Therefore, a highly reliable semiconductor device including a multi-layer interconnect with a low resistance and excellent adhesion can be achieved. Moreover, adhesion with an insulation film can be improved and electroplating for forming an excellent interconnect becomes possible.

According to a method for fabricating a semiconductor device according to the present invention, a metal compound film is formed and then a metal film is formed by physical vapor deposition. Thus, electrically neutral metal particles and metal particle ions enter a surface of the metal compound film at high speed (with high energy), so that a fusion layer is formed in the vicinity of an interface between the metal compound film and the metal film so as to extend from the interface and has an approximately intermediate composition between those of the films. Accordingly, compared to the case where the metal compound film and the metal film are merely stacked, adhesion between the metal compound film and the metal film can be remarkably improved. Therefore, a highly reliable semiconductor device including a multi-layer interconnect with a low resistance and excellent adhesion can be fabricated.

Moreover, according to the method for fabricating a semiconductor device according to the present invention, the metal compound film is formed so as to be jointed with an insulation film and the metal film is formed on the metal compound film. Thus, the metal film having a smaller resistance than that of the metal compound film serves as an electrode and an underlying layer in electroplating for interconnect. Accordingly, compared to the case where electroplating for interconnect is performed to a surface of the metal compound film, uniform electroplating for interconnect can be achieved. Moreover, the metal film is formed of a metal which does not loose its conductivity when being oxidized. Therefore, when a surface of the metal film is oxidized in electroplating for interconnect, a conductivity of the metal film is not reduced and high performance electroplating for interconnect can be achieved. Moreover, the metal compound film and the insulation film are jointed with each other. Accordingly, compared to the case where the metal film and the insulation film are jointed with each other, far more excellent adhesion can be achieved. Moreover, excellent adhesion can be achieved at an interface between adjacent two of the insulation film, the metal compound film, the fusion layer, the metal film and the interconnect formed in this order. Accordingly, overall adhesion is largely improved. Therefore, a highly reliable semiconductor device including a multi-layer interconnect with a low resistance and excellent adhesion can be achieved.

### BRIEF DESCRIPTION OF DRAWINGS

FIGS. **1(a)** and **1(b)** are cross-sectional views illustrating relevant part of a structure of a semiconductor device according to a first embodiment of the present invention.
FIGS. **2(a)** and **2(b)** illustrate states of film composition of a second barrier metal film according to the first embodiment of the present invention.
FIGS. **3(a)** and **3(b)** are cross-sectional views illustrating relevant part of a structure of a semiconductor device according to a second embodiment of the present invention.
FIGS. **4(a)** and 4(b) illustrate states of film composition of a second barrier metal film according to the second embodiment of the present invention.
FIGS. **5(a)** and **5(b)** are cross-sectional views of relevant part of a semiconductor device according to a third embodiment of the present invention illustrating respective steps for fabricating the semiconductor device.
FIGS. **6(a)** and **6(b)** are cross-sectional views of relevant part of a semiconductor device according to the third embodiment of the present invention illustrating respective steps for fabricating the semiconductor device.
FIG. **7** is a cross-sectional view of relevant part of a semiconductor device according to a modified example of the third embodiment of the present invention illustrating respective steps for fabricating the semiconductor device.
FIGS. **8(a)** and **8(b)** are cross-sectional views illustrating relevant part of a structure of a known semiconductor device.

### BEST MODE FOR CARRYING OUT THE INVENTION

### (First Embodiment)

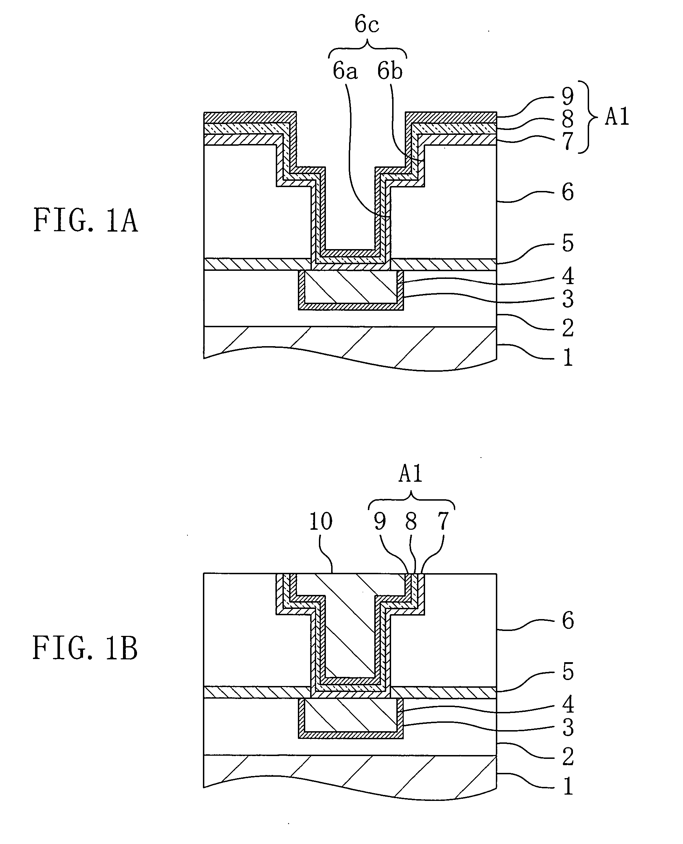

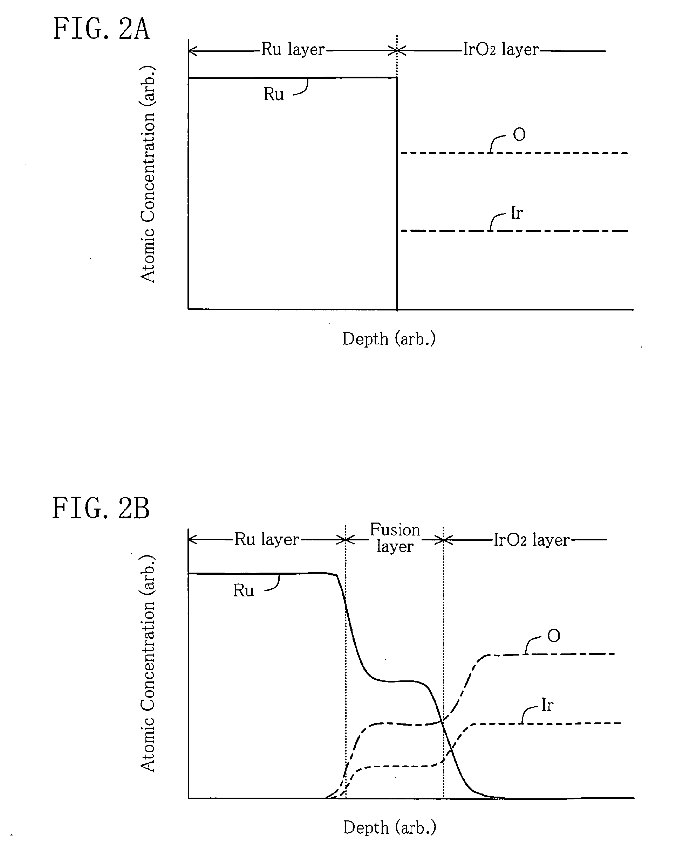

A semiconductor device according to a first embodiment of the present invention will be described with reference to FIGS. **1(a)** and **1(b)** and FIGS. **2(a)** and **2(b).**

FIGS. **1(a)** and **1(b)** are cross-sectional views illustrating relevant part of a structure of the semiconductor device of the first embodiment.

First, as shown in FIG. **1(a),** a first insulation film **2** is formed on a silicon substrate **1.** A first copper interconnect **4** including a first barrier metal film **3** is formed in the first insulation film 2. On the silicon substrate **1,** a transistor and the like (not shown) are formed. A dielectric barrier film **5** for preventing diffusion of copper and a second insulation film **6** are formed in this order over the first insulation film **2** and the first copper interconnect **4.** A via hole **6a** is formed in the dielectric barrier film **5** and the second insulation film 6 and an interconnect trench **6b** is formed in the second insulation film **6.** Thus, a recess portion **6c** including the via hole **6a** and the interconnect trench **6b** is obtained.

As shown in FIG. **1(a),** a second barrier metal film **A1** is formed over surfaces of the recess portion **6c.** The second barrier metal film **A1** includes a metal compound film **7** formed on the second insulation film **6** to cover the surfaces of the recess portion **6c,** a fusion layer **8** formed on the metal compound film **7** and a metal film **9** which is formed on the fusion layer **8** and does not loose its conductivity when being oxidized. The metal film **9** is formed of a different metal from a metal forming the metal compound film 7. As described above, in this embodiment, the case where a metal forming the metal compound film **7** and a metal forming the metal film **9** are different from each other is described. This is different from a second embodiment of the present invention, which will be later described. The fusion layer **8** is formed in the vicinity of an interface between the metal compound film **7** and the metal film **9** and has an intermediate composition between respective compositions of the metal compound film **7** and the metal film **9.** At least part of the metal film **9** may be oxidized.

Furthermore, a copper film is formed over the metal film **9** by copper electroplating so as to fill the recess portion **6c** shown in FIG. **1(a).** Thereafter, parts of the copper film and the barrier metal film **A1** located over the second insulation film **6,** except for parts thereof located inside the recess portion **6c,** are removed by CMP to form a second copper interconnect **10** including a via plug. Thus, a semiconductor device having the structure of FIG. **1(b)** is obtained. Note that the second copper interconnect **10** may be an interconnect, a via plug, or a combination of an interconnect and a via plug. The second copper interconnect **10** may be formed of a copper alloy containing some other component than pure copper or copper (such as a small amount of Si, Al, Mo and Sc). A multi-layer interconnect is formed by repetition of the process steps from formation of the dielectric barrier film 5 to CMP.

As the dielectric barrier film **5,** a silicon nitride film, a silicon nitride carbide film, a silicon carbide oxide film, a silicon carbide film or a lamination film formed of a combination of these films is preferably used. The dielectric barrier film **5** has the function of preventing diffusion of copper of the first copper interconnect **4** in the second insulation film **6.**

As the second insulation film **6,** an insulation film formed of a silicon oxide film, a fluorine-doped silicon oxide film, a silicon oxide carbide film, or an organic film is preferably used. Each of these insulation films may be a film formed by chemical vapor deposition or may be a SOD (spin on dielectric) film formed by spin coating.

The recess portion **6c** including the via hole **6a** and the interconnect trench **6b** is preferably formed, for example, by a dual damascene process disclosed in Japanese Laid-Open Publication No. 2002-75994 or the like, using known lithography, etching, ashing and cleaning.

As a metal forming the metal compound film 7, a high malting point metal is preferably used. Thus, in the step of forming an interconnect in an upper layer after formation of the second copper interconnect **10,** even when heat of about 400 °C is applied, the metal compound film 7 is not altered by the heat treatment. Therefore, a highly reliable semiconductor device can be achieved.

When the metal compound film 7 has a small thickness, the metal compound film **7** does not necessarily have conductivity. However, the metal compound film 7 preferably has conductivity. Hereinafter, the metal compound film 7 having conductivity will be specifically described.

First, as the metal compound film 7, an oxide film of a metal, such as ruthenium (Ru), iridium (Ir), molybdenum (Mo), osmium (Os), rhodium (Rh), platinum (Pt), vanadium (V) and palladium (Pd), which does not loose its conductivity when being oxidized is preferably used. Needless to say, an oxide film of some other metal than the metals described above may be used as the metal compound film 7, as long as the metal is a metal which does not loose its conductivity when being oxidized.

As the metal compound film **7,** a nitride film of a metal, such as titanium (Ti), tantalum (Ta), zirconium (Zr), niobium (Nb), hafnium (Hf) and tungsten (W), which does not loose its conductivity when being nitrided is preferably used. Needless to say, a nitride film of some other metal than the metals described above may be used as the metal compound film 7, as long as the metal is a metal which does not loose its conductivity when being nitrided.

As the metal compound film **7,** a carbide film of a metal, such as ruthenium (Ru), iridium (Ir), molybdenum (Mo), osmium (Os), rhodium (Rh), platinum (Pt), vanadium (V), titanium (Ti), tantalum (Ta), zirconium (Zr), niobium (Nb), hafnium (Hf), tungsten (W) and palladium (Pd) is preferably used. Needless to say, a carbide film of some other metal than the metals described above may be used as the metal compound film 7, as long as the metal is a metal which does not loose its conductivity when being carbonized.

As the metal compound film 7, a silicide film of a refractory metal is preferably used.

The metal compound film 7 is preferably formed by atomic layer deposition (ALD), chemical vapor deposition (CVD), physical vapor deposition (PVD) or like film formation method.

Next, as the metal film **9,** a metal, such as ruthenium (Ru), iridium (Ir), molybdenum (Mo), osmium (Os), rhodium (Rh), platinum (Pt), vanadium (V) and palladium (Pd), which does not loose its conductivity when being oxidized is preferably used. Needless to say, an oxide film of some other metal than the metals described above may be used as the metal film **9,** as long as the metal is a metal which does not loose its conductivity when being oxidized.

It is preferable that the metal film **9** is formed by physical vapor deposition (PVD).

The reason why PVD is preferable is as follows. As shown in the known example, when the metal film **9** is formed by atomic layer deposition or chemical vapor deposition, the metal film **9** can be formed on the metal compound film **7** but the fusion layer **8** can not be formed between the metal compound film **7** and the metal film **9.** That is, a film is grown by thermal chemical reaction on the atomic level in atomic layer deposition and on the molecular level in chemical vapor deposition. In contrast, when the metal film **9** is formed on the metal compound film **7** using physical vapor deposition represented by sputtering, electrically neutral metal particles and metal particle ions enter a surface of the metal compound film **7** at high speed (with high energy), so that the fusion layer **8** is formed in the vicinity of an interface between the metal compound film **7** and the metal film **9** so as to extend from the interface. Accordingly, adhesion of the metal compound film **7** and the metal film **9** is remarkably improved, compared to the case where the metal compound film **7** and the metal film **9** are merely stacked by thermal chemical reaction. Therefore, a highly reliable semiconductor device including a multi-layer interconnect with a low resistance and excellent adhesion can be achieved.

Although not shown in the drawings, an insulation film such as a silicon oxide film (e.g., SiO₂, SiOC, SiCO, SiON or the like), a silicon nitride film (e.g., Si₃N₄, SiON, SiCN or the like) and a silicon carbide film (e.g., SiC, SiCO, SiOC, SiCN or the like) may be formed between parts of a surface of the second insulation film 6 and the metal compound film **7** located inside a dual damascene trench (i.e., the recess portion 6c including the via hole **6a** and the interconnect trench **6b).**

As has been described, in the first embodiment, the metal of the metal compound film **7** and the metal of the metal film **9** are different from each other. Thus, a fusion layer formed in the vicinity of the interface between the metal compound film **7** and the metal film **9** so as to extend from the interface becomes an alloy layer containing two kinds of metal as main components.

FIGS. **2(a)** and **2(b)** illustrate states of film composition of a barrier metal film when iridium (Ir) which is a metal for forming a metal oxide film is used as an example of the metal compound film 7 and ruthenium (Ru) is used as an example of metal of the metal film **9.**

FIG. **2(a)** illustrates states of film composition for part of a semiconductor device extending from the metal compound film 7 to the metal film **9** when the metal film **9** is formed by atomic layer deposition or chemical vapor deposition. FIG. **2(b)** illustrates states of film composition for part of a semiconductor device of the first embodiment of the present invention extending from the metal compound film **7** and the metal film **9.** More specifically, FIG. **2(b)** illustrates states of film composition for the part of the semiconductor device extending from the metal compound film **7** through the metal film **9** when the metal film **9** is formed by physical vapor deposition.

First, as shown in FIG. **2(a),** when the metal film **9** is formed by atomic layer deposition or chemical vapor deposition, a fusion layer is not formed at an interface between IrO₂ of a metal oxide film as the metal compound film 7 and Ru as the metal film **9.** This is because atomic layer deposition and chemical vapor deposition are methods in which a film is formed by thermal chemical reaction. Therefore, shear stress generated by application of stress to an entire film concentrates at the interface between IrO₂ and Ru, so that film exfoliation at the interface tends to occur.

On the other hand, as shown in FIG. **2(b),** when the metal film **9** is formed by physical vapor deposition, electrically neutral metal particles or metal particle ions with high energy enter a surface of a metal oxide film. Accordingly, the fusion layer **8** which is an alloy layer is formed at the interface between IrO₂ which is a metal oxide film as the metal compound film 7 and Ru as the metal film **9.** Herein, a particle means a single atom or a cluster of two or more atoms. Therefore, a film composition of the fusion layer **8** formed in the vicinity of the interface between the metal compound film **7** and the metal film **9** so as to extend from the interface is an approximately intermediate composition between respective film compositions of the composition of the metal oxide film and the metal film **9.** Thus, no clear interface between IrO₂ which is a metal oxide film and Ru as the metal film **9** exists, and therefore, even with application of stress to an entire film, stress such as shear stress does not concentrate. Accordingly, the second barrier metal film **A1** having strong resistance to stress is obtained.

By adjusting conditions for physical vapor deposition used in formation of the metal film **9,** the fusion layer **8** formed in the vicinity of the interface between the metal oxide film as the metal compound film **7** and the metal film **9** so as to extend from the interface can be made to have a metal-rich film composition or a film composition close to the metal composition of the metal oxide film.

In FIGS. **2(a)** and **2(b),** the case where a metal oxide film is an example of the metal compound film 7 is described. However, even when, instead of the metal oxide film, a metal nitride film, a metal carbide film, a metal silicide film or the like is used as an example of the metal compound film 7, the same effects as in the case where a metal oxide film is used can be achieved.

The fusion layer **8** provided in the vicinity of the interface between the metal compound film **7** and the metal film **9** is formed so as to correspond to at least several or more atomic layers. In other words, the fusion layer **8** preferably has a thickness enough to cover unevenness of an underlying film at an atomic layer level. In this case, the fusion layer **8** is formed in an entire area at which the metal compound film 7 and the metal film **9** are in contact and therefore, adhesion of the metal compound film 7 and the metal film **9** is remarkably improved.

Also, as shown in FIG. **1(b),** it is more preferable that the metal film **9** forming the second barrier metal **A1** is in contact with the second copper interconnect **10** made of copper of a copper alloy. In such a case, the metal film **9** having a smaller resistance than that of the metal compound film 7 serves as an electrode used in copper electroplating and an underlying layer for copper electroplating. Therefore, compared to the case where copper is plated directly on the metal compound film **7** to form the second copper interconnect **10,** a uniform copper electroplating can be obtained. Moreover, when the metal film 9 is in contact with the second copper interconnect **10** in the above-described manner, the metal compound film 7 and the second insulation film **6** are jointed with each other and therefore, far greater adhesion is exhibited between the metal compound film **7** and the second insulation film **6,** compared to the case where the metal film **9** is jointed with the second insulation film **6.** Furthermore, excellent adhesion can be achieved at an interface between the second insulation film **6** and the metal compound film 7, an interface between the metal compound film 7 an the fusion layer **8,** an interface between the fusion layer **8** and the metal film **9** and an interface between the metal film **9** and the second copper interconnect **10,** so that a structure having overall excellent adhesion can be achieved.

Next, an example of combination of respective resistivities of metals used as the metal compound film 7 and the metal film 9 of the first embodiment will be described.

The resistivity of ruthenium is 7.5 (µΩ/cm) and the resistivity of iridium is 6.5 (µΩ/cm). Moreover, the resistivity of a ruthenium oxide film is 35 (µΩ/cm) and the resistivity of an iridium oxide film is 30 (µΩ/cm). The resistivity of tantalum regularly used at present is 13 (µΩ/cm) and the resistance of a tantalum nitride film is 130 (µΩ/cm).

Accordingly, assume that the second barrier metal film **A1** is formed of a metal which does not loose its conductivity when being oxidized and a metal oxide film of the metal. Even when at least part of the metal forming the second barrier metal film **A1** is oxidized, a barrier metal film having a lower resistance than that of a tantalum nitride film which is often used as a barrier metal film at present can be formed as the second barrier metal film **A1.** Even when the second barrier metal **A1** is formed of a metal which doe not loose its conductivity when being oxidized and a tantalum nitride film, a sufficiently low resistant and practical barrier metal film can be formed.

When the second barrier metal film **A1** shown in this embodiment is incorporated in an actual semiconductor device, the metal compound film **7** is preferably formed so as to have a thickness of about several to 25 nm and the metal film **9** is preferably formed so as to have a thickness of about several to 25 nm. In such a case, the thickness of the second barrier metal film **A1** as a whole is preferably 20-30 nm in a 65 nm generation semiconductor device. In a 45 nm generation semiconductor device, it is expected that the thickness of the second barrier metal film **A1** as a whole has to be about 15 mn or less at most. The film thickness ratio between the metal compound film 7 and the metal film **9** is preferably optimized in an arbitrary manner according to a film formation method and its application.

In this embodiment, when a metal oxide film is used as the metal compound film 7, and, specifically, when an upper surface of the second insulation film is formed of a silicon oxide film, adhesion between the metal compound film 7 and the second insulation film **6** can be further increased. Accordingly, a highly reliable semiconductor device including a multi-layer interconnect with excellent adhesion can be achieved.

Moreover, in this embodiment, when a metal nitride film is used as the metal compound film **7** and, specifically, when the upper surface of the second insulation film is formed of a silicon nitride film, adhesion between the metal compound film **7** and the second insulation film **6** can be further increased. Accordingly, a highly reliable semiconductor device including a multi-layer interconnect with excellent adhesion can be achieved.

Moreover, in this embodiment, when a metal carbide film is used as the metal compound film 7 and, specifically, when the upper surface of the second insulation film **6** is formed of a silicon carbide film or an organic film, adhesion between the metal compound film **7** and the second insulation film **6** can be further increased. Accordingly, a highly reliable semiconductor device including a multi-layer interconnect with excellent adhesion can be achieved.

Furthermore, in this embodiment, a metal silicide film is used as the metal compound film **7** and, specifically, when the upper surface of the second insulation film **6** is formed of an insulation film containing silicon, adhesion between the metal compound film **7** and the second insulation film 6 can be further increased. Accordingly, a highly reliable semiconductor device including a multi-layer interconnect with excellent adhesion can be achieved.

In the above-described manner, excellent adhesion can be achieved in an interface between any adjacent two of the second insulation film **6,** the metal compound film 7, the fusion layer **8,** the metal film 9 and the second copper interconnect **10.** Therefore, a semiconductor device having excellent adhesion as a whole can be achieved.

As has been described, according to the first embodiment of the present invention, a highly reliable semiconductor device including a multi-layer interconnect with a low resistance and excellent adhesion can be achieved.

In this embodiment, the case where a dual damascene structure is adopted has been described. However, needless to say, even when a single damascene structure is adopted, the same effects as those in the case of adoption of a dual damascene structure can be achieved. When a single damascene structure is adopted, an interconnect and a via plug are formed in separate steps. In such a case, the interconnect and the via plug are included in a buried interconnect, i.e., the second copper interconnect **10** of this embodiment.

Moreover, in this embodiment, the case where copper or a copper alloy is used as a material of the buried interconnect, i.e., the second copper interconnect **10** has been described. In this embodiment, it is more preferable that a metal such as Ag, Au and Pt having a lower resistance than that of copper, or an alloy of the metal is used as a material of the buried interconnect.

### (Second Embodiment)

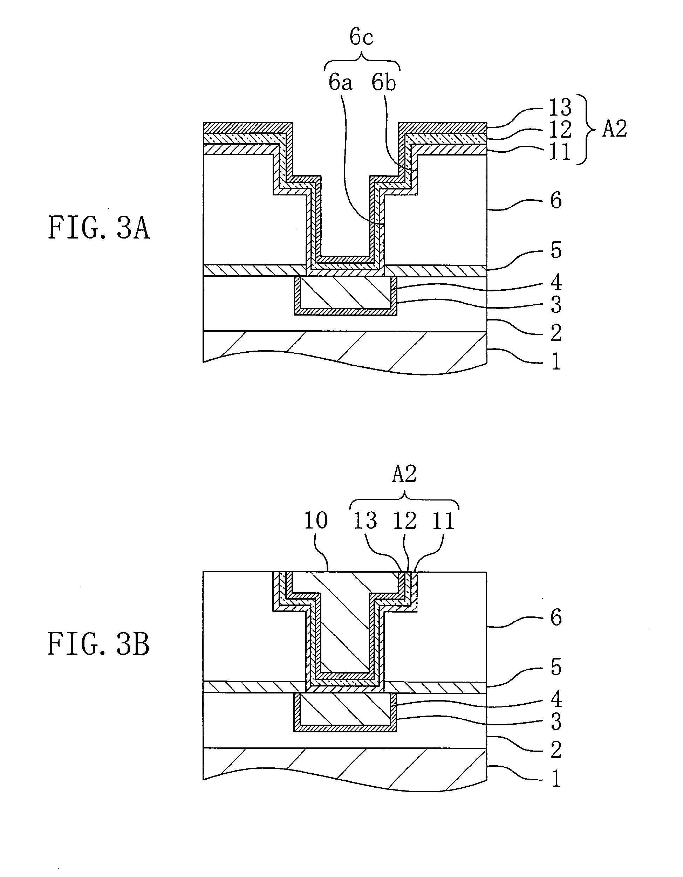

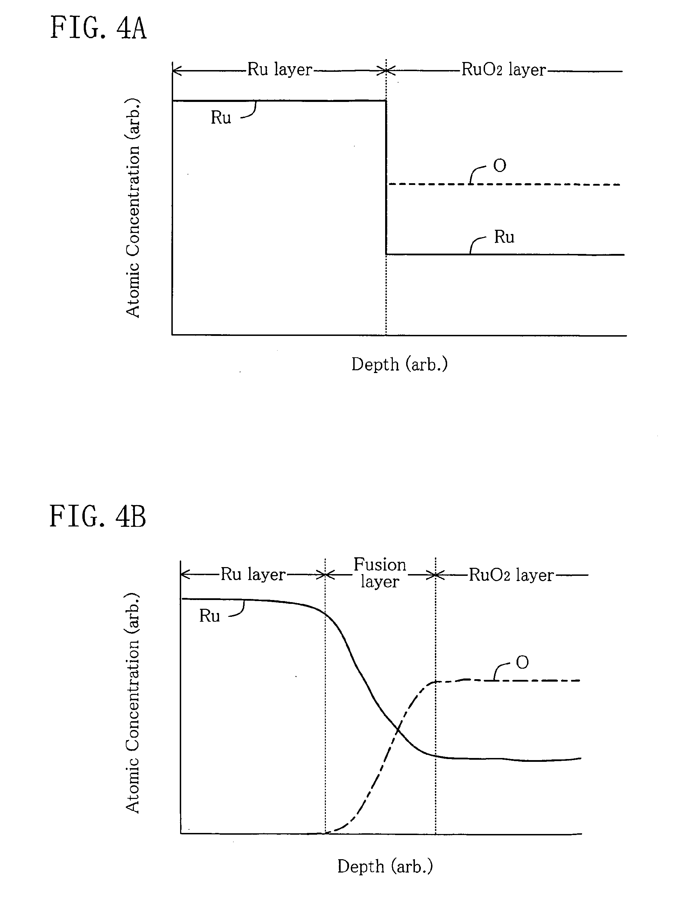

Hereinafter, a semiconductor device according to a second embodiment of the present invention will be described with reference to FIGS. **3(a)** and **3(b)** and FIGS. **4(a)** and **4(b).**

First, FIGS. **3(a)** and **3(b)** are cross-sectional views illustrating relevant part of a structure of the semiconductor device of the second embodiment. In the second embodiment, the description of part of the second embodiment described also in the first embodiment is not repeated. The following description will be given focusing on different points from the first embodiment.

As shown in FIG. **3(a),** a barrier metal film **A2** is formed on surfaces of a recess portion **6c.** In this embodiment, the second barrier metal film **A2** is formed of a metal compound film **11,** a fusion layer **12** formed on the metal compound film **11** and a metal film **13** which is formed on the fusion layer **12** and does not loose its conductivity when being oxidized.

In this embodiment, the metal film **13** is formed of the same metal as a metal of the metal compound film **11.** This embodiment is different from the second embodiment in which the metal forming the metal compound film **7** and the metal forming the metal film **9** are different from each other in that the metal forming the metal compound film **11** and the metal forming the metal film **13** are the same (see FIGS. **3(a)** and **3(b)).** The fusion layer **12** is formed in the vicinity of an interface between the metal compound film **11** and the metal film **13** which does not loose its conductivity when being oxidized so as to extend from the interface. The fusion layer **12** has an oxygen concentration gradient shown in FIG. **4(b)** and is a mixing layer of the metal compound film **11** and the metal film **13** which does not loose its conductivity.

FIGS. **4(a)** and **4(b)** illustrate states of film composition of a barrier metal film when ruthenium (Ru) is used as an example of the metal compound film **7** and ruthenium (Ru) is used as an example of metal of the metal compound film **11** and the metal film **13.**

FIG. **4(a)** illustrates states of film composition for part of a semiconductor device extending from the metal compound film **11** to the metal film **13** when the metal film **11** is formed by atomic layer deposition or chemical vapor deposition. FIG. **4(b)** illustrates states of film composition for part of a semiconductor device extending from the metal compound film **11** and the metal film **13** according to the second embodiment of the present invention. More specifically, FIG. **4(b)** illustrates states of film composition for the part of the semiconductor device extending from the metal compound film **11** through the metal film **13** when the metal film **13** is formed by physical vapor deposition.

First, as shown in FIG. **4(a),** when the metal film **13** is formed by atomic layer deposition or chemical vapor deposition, a fusion layer (mixing layer) is not formed at an interface between RuO₂ of a metal oxide film as the metal compound film **11** and Ru as the metal film **13.** This is because atomic layer deposition and chemical vapor deposition are methods in which a film is formed by thermal chemical reaction. Therefore, shear stress generated by application of stress to an entire film concentrates at the interface between RuO₂ and Ru, so that film exfoliation at the interface tends to occur.

On the other hand, as shown in FIG. **4(b),** when the metal film **13** is formed by physical vapor deposition, electrically neutral metal particles or metal particle ions with high energy enter a surface of a metal oxide film. Accordingly, the fusion layer (mixing layer) **12** which is an alloy layer is formed at the interface between RuO₂ which is a metal oxide film as the metal compound film **11** and Ru as the metal film **13.** Therefore, a film composition of the fusion layer (mixing layer) **12** formed in the vicinity of the interface between the metal oxide film as the metal compound film **11** and the metal film **13** so as to extend from the interface is an approximately intermediate composition between respective film compositions of the metal oxide film and the metal film **13.** In such a case, no clear interface between RuO₂ of a metal oxide film and Ru as the metal film **13** exists, and therefore, even with application of stress to an entire film, stress such as shear stress does not concentrate. Accordingly, the second barrier metal film **A2** having a strong resistance to stress is formed.

As has been described, in this embodiment, the metal forming the metal compound film **11** and the metal forming the metal film **13** are the same and the metal compound film **11** and the metal film **13** are integrated with the mixing layer interposed therebetween, so that adhesion between a metal compound film and a metal film can be improved even more than in the first embodiment. Other than that, the second embodiment is the same as the first embodiment and, according to this embodiment, the same effects as those of the first embodiment can be achieved.

Therefore, according to the second embodiment of the present invention, a highly reliable semiconductor device having a multi-layer interconnect with a low resistance and excellent adhesion can be achieved.

### (Third Embodiment)

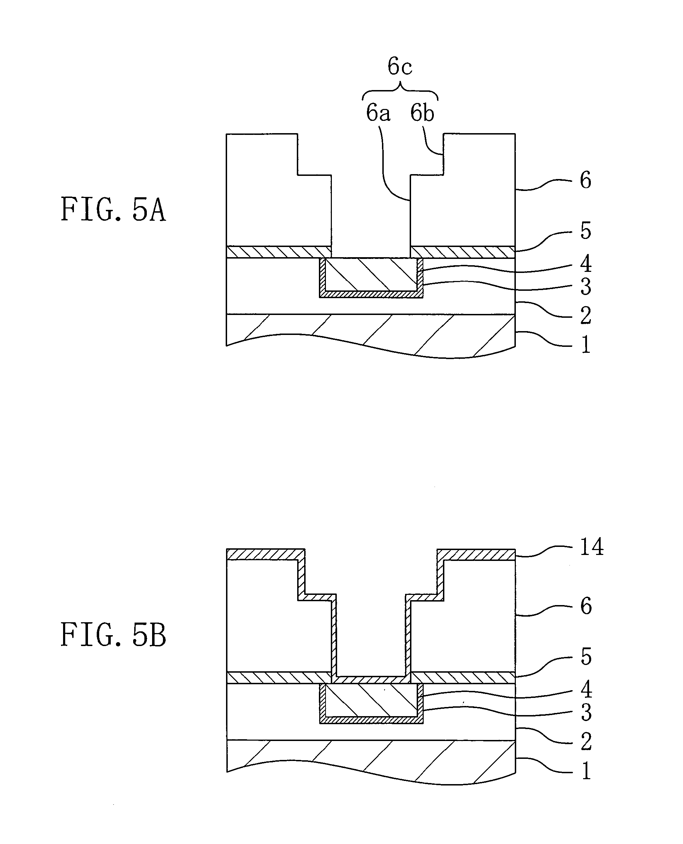

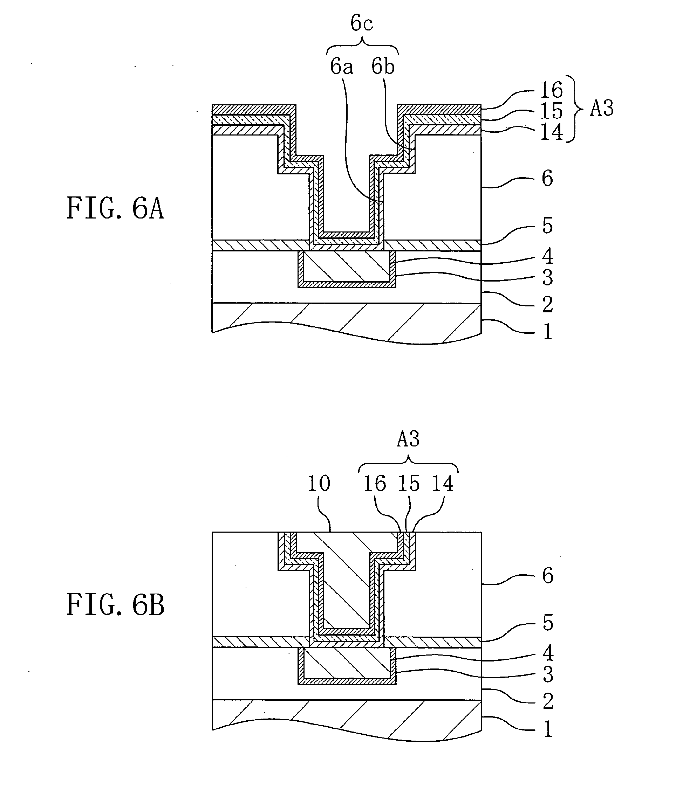

Hereinafter, a method for fabricating a semiconductor device according to a third embodiment of the present invention will be described with reference to FIGS. **5(a)** and **5(b)** and FIGS. **6(a)** and **6(b).**

First, FIGS. **5(a)** and **5(b)** and FIGS. **6(a)** and **6(b)** are cross-sectional views of relevant part of a semiconductor device according to the third embodiment of the present invention illustrating respective steps for fabricating the semiconductor device.

First, as shown in FIG. **5(a),** a first insulation film 2 is formed on a silicon substrate 1 and then a first copper interconnect **4** including in a first barrier metal film **3** is formed in the first insulation film **2.** Although not shown in the drawings, a transistor and the like are formed on the silicon substrate **1.** Subsequently, a dielectric barrier film 5 for preventing diffusion of copper and a second insulation film **6** are formed in this order over the first insulation film **2** and the first copper interconnect **4.** Next, a via hole **6a** is formed in the dielectric barrier film **5** and the second insulation film **6** so that a bottom of the via hole **6a** reaches the first copper interconnect **4** and an interconnect trench **6b** is formed so as to communicate to the via hole **6a.** Thus, a recess portion **6c** including the via hole **6a** and the interconnect trench **6b** is obtained.

In this embodiment, as the dielectric barrier film **5,** a silicon nitride film, a silicon nitride carbide film, a silicon carbide oxide film, a silicon carbide film or a lamination film formed of a combination of these films is preferably used. The dielectric barrier film 5 has the function of preventing diffusion of copper of the first copper interconnect **4** in the second insulation film **6.**

As the second insulation film **6,** an insulation film formed of a silicon oxide film, a fluorine-doped silicon oxide film, a silicon oxide carbide film, or an organic film is preferably used. Each of these insulation films may be a film formed by chemical vapor deposition or may be a SOD (spin on dielectric) film formed by spin coating.

The recess portion **6c** including the via hole **6a** and the interconnect trench **6b** is preferably formed, for example, by a dual damascene process disclosed in Japanese Laid-Open Publication No. 2002-75994 or the like using known lithography, etching, ashing and cleaning.

Next, as shown in FIG. **5(b),** a metal compound film **14** is formed on the second insulation film so as to cover surfaces of the recess portion **6c.** In this embodiment, the metal compound film **14** is preferably formed by atomic layer deposition (ALD), chemical vapor deposition (CVD), physical vapor deposition (PVD) or like film formation method.

Next, as shown in FIG. **6(a),** a metal film **16** which does not loose its conductivity when being oxidized is formed on the metal compound film **14** by physical vapor deposition (PVD). When the metal film **16** is formed using physical vapor deposition in the above-described manner, as shown in FIG. **6(a),** a fusion layer **15** is formed of parts of the metal compound film **14** and the metal film **16** between the metal compound film **14** and the metal film **16.** As physical vapor deposition, sputtering is used, in general. However, some other physical vapor deposition may be used. Thus, a second barrier metal film **A3** including the metal compound film **14,** a fusion layer **15** and the metal film **16** is obtained.

The reason why the metal film 16 is formed by physical vapor deposition is as follows. As shown in the known example, when the metal film **16** is formed by atomic layer deposition or chemical vapor deposition, the metal film **16** can be formed on the metal compound film **14** but the fusion layer **15** can not be formed between the metal compound film **14** and the metal film **16.** That is, a film is grown by thermal chemical reaction on the atomic level in atomic layer deposition and on the molecular level in chemical vapor deposition. In contrast, when the metal film **16** is formed on the metal compound film **14** using physical vapor deposition represented by sputtering, electrically neutral metal particles and metal particle ions enter a surface of the metal compound film**14** at high speed (with high energy), so that the fusion layer **15** is formed in the vicinity of an interface between the metal compound film **14** and the metal film **16** so as to extend from the interface. Accordingly, adhesion of the metal compound film **14** and the metal film **16** is remarkably improved, compared to that case where the metal compound film **14** and the metal film **16** are merely stacked by thermal chemical reaction. Therefore, a highly reliable semiconductor device including a multi-layer interconnect with a low resistance and excellent adhesion can be achieved.

Next, as shown in FIG. **6(b),** a copper film is formed over the metal film **16** as well as inside the recess portion **6c** by copper electroplating so as to fill the recess portion **6c.** Thereafter, parts of the copper film, the metal film **16,** the fusion layer **15** and the metal compound film **14** located over the second insulation film **6,** except for parts thereof located inside of the recess portion **6c,** is removed by CMP to form a second copper interconnect **10** including a via plug. Thus, a semiconductor device having the structure of FIG. **6(b)** is obtained. Note that the second copper interconnect **10** may be an interconnect, a via plug, or a combination of an interconnect and a via plug. The second copper interconnect **10** may be formed of a copper alloy containing some other component (such as a small amount of Si, Al, Mo and Sc) than pure copper or copper. A multi-layer interconnect is formed by repetition of the process steps from formation of the dielectric barrier film **5** to CMP. Note that in formation of the second copper interconnect 10, even if part of the metal film **16** is oxidized, the metal film **16** as a whole does not loose its conductivity.

By adjusting conditions for physical vapor deposition used in formation of the metal film **16,** the fusion layer **15** formed in the vicinity of the interface between the metal oxide film as the metal compound film **14** and the metal film **16** so as to extend from the interface can be made to have a metal-rich film composition or a film composition close to the metal composition of the metal oxide film.

Moreover, in FIG. **6(b),** when the metals of the metal compound film **14** and the metal film **16** are different from each other, as described in the first embodiment, the fusion layer **15** is an alloy layer containing the two kinds of metal as main components. Also, when the metals of the metal compound film **14** and the metal film **16** are the same, as described in the second embodiment, the fusion layer **15** is a mixing layer of the metal compound film **14** and the metal film **16.** In either one of the cases, as in the first and second embodiments, adhesion between the metal compound film **14** and the metal compound film **16** is remarkably improved, compared to the case where the metal compound film **14** and the metal film **16** are mealy stacked by thermal chemical reaction. Therefore, a highly reliable semiconductor device including a multi-layer interconnect with a low resistance and excellent adhesion can be fabricated.

As a metal forming the metal compound film **14,** a high malting point metal is preferably used. Thus, in the step of forming an interconnect in an upper layer after formation of the second copper interconnect **10,** even when heat of about 400 °C is applied, the metal oxide film **14** is not altered by the heat treatment. Therefore, a highly reliable semiconductor device can be achieved.

When the metal compound film **14** has a small thickness, the metal compound film **14** does not necessarily have conductivity. However, it is preferable that the metal compound film **14** has conductivity. Hereinafter, the metal compound film **14** having conductivity will be specifically described.

First, as the metal compound film **14,** an oxide film of a metal, such as ruthenium (Ru), iridium (Ir), molybdenum (Mo), osmium (Os), rhodium (Rh), platinum (Pt), vanadium (V) and palladium (Pd), which does not loose its conductivity when being oxidized is preferably used. Needless to say, an oxide film of some other metal than the metals described above may be used as the metal compound film **14,** as long as the metal is a metal which does not loose its conductivity when being oxidized.

As the metal compound film **14,** a nitride film of a metal, such as titanium (Ti), tantalum (Ta), zirconium (Zr), niobium (Nb), hafnium (Hf) and tungsten (W), which does not loose its conductivity when being nitrided is preferably used. Needless to say, a nitride film of some other metal than the metals described above may be used as the metal compound film **14,** as long as the metal is a metal which does not loose its conductivity when being nitrided.

As the metal compound film **14,** a carbide film of a metal, such as ruthenium (Ru), iridium (Ir), molybdenum (Mo), osmium (Os), rhodium (Rh), platinum (Pt), vanadium (V), titanium (Ti), tantalum (Ta), zirconium (Zr), niobium (Nb), hafnium (Hf), tungsten (W) and palladium (Pd) is preferably used. Needless to say, a carbide film of some other metal than the metals described above may be used as the metal compound film **14,** as long as the metal is a metal which does not loose its conductivity when being carbonized.

As the metal compound film **14,** a silicide film of a refractory metal is preferably used.

Next, as the metal film **16,** a metal, such as ruthenium (Ru), iridium (Ir), molybdenum (Mo), osmium (Os), rhodium (Rh), platinum (Pt), vanadium (V) and palladium (Pd), which does not loose its conductivity when being oxidized is preferably used. Needless to say, an oxide film of some other metal than the metals described above may be used as the metal film **16,** as long as the metal is a metal which does not loose its conductivity when being oxidized.

Although not shown in the drawings, an insulation film such as a silicon oxide film (e.g., SiO₂, SiOC, SiCO, SiON or the like), a silicon nitride film (e.g., Si₃N₄, SiON, SiCN or the like) and a silicon carbide film (e.g., SiC, SiCO, SiOC, SiCN or the like) may be formed between parts of a surface of the second insulation film **6** and the metal compound film 7 located inside a dual damascene trench (i.e., the recess portion **6c** including the via hole **6a** and the interconnect trench **6b).**

Next, an example of combination of respective resistivities of metals used as the metal compound film **14** and the metal film **16** of the third embodiment will be described.

The resistivity of ruthenium is 7.5 (µΩ/cm) and the resistivity of iridium is 6.5 (µΩ/cm). Moreover, the resistivity of a ruthenium oxide film is 35 (µΩ/cm) and the resistivity of an iridium oxide film is 30 (µΩ/cm). The resistivity of tantalum regularly used at present is 13 (µΩ/cm) and the resistance of a tantalum nitride film is 130 (µΩ/cm).

Accordingly, assume that the second barrier metal film **A3** is formed of a metal which does not loose its conductivity when being oxidized and a metal oxide film of the metal. Even when at least part of the metal forming the second barrier metal film **A3** is oxidized, a barrier metal film having a lower resistance than that of a tantalum nitride film which is often used as a barrier metal film at present can be formed as the second barrier metal film **A3.** Even when the second barrier metal film **A3** is formed of a metal which doe not loose its conductivity when being oxidized and a tantalum nitride film, a sufficiently low resistant and practical barrier metal film can be formed.

When the second barrier metal film A3 shown in this embodiment is incorporated in an actual semiconductor device, the metal compound film **14** is preferably formed so as to have a thickness of about several to 25 nm and the metal film **16** is preferably formed so as to have a thickness of about several to 25 nm. In such a case, the thickness of the second barrier metal film **A3** as a whole is preferably 20-30 nm in a 65 nm generation semiconductor device. In a 45 nm generation semiconductor device, it is expected that the thickness of the second barrier metal film **A3** as a whole has to be about 15 nm or less at most. The film thickness ratio between the metal compound film **14** and the metal film **16** is preferably optimized in an arbitrary manner according to a film formation method and its application. The metal compound film **14** is preferably formed by ALD so as to have a reduced thickness according to reduction in thickness of the second barrier metal film **A3.**

Also, as shown in FIG. **6(b),** the second copper interconnect **10** is formed on the metal film **16** forming the second barrier metal film **A3.** In such a case, the metal film **16** having a smaller resistance than that of the metal compound film **14** serves as an electrode used in copper electroplating and an underlying layer for copper electroplating. Therefore, compared to the case where copper is plated directly on the metal compound film **14** to form the second copper interconnect **10,** a uniform copper electroplating can be obtained. The metal film **16** is hardly oxidized during copper electroplating and has conductivity when being oxidized. Therefore, excellent copper electroplating performance can be achieved.

If a semiconductor device is fabricated in the above-described manner, the metal compound film **14** and the second insulation film 6 are jointed with each other. Thus, compared to the case where the metal film **16** and the second insulation film 6 are jointed with each other, adhesion between the metal compound film **14** and the second insulation film **6** is far more excellent. Furthermore, excellent adhesion can be achieved at an interface between the second insulation film **6** and the metal compound film **14,** an interface between the metal compound film **14** an the fusion layer **15,** an interface between the fusion layer **15** and the metal film **16** and an interface between the metal film **16** and the second copper interconnect **10,** so that a structure having overall excellent adhesion can be achieved.

The effects described above are achieved by using a metal oxide film, a metal nitride film, a metal carbide film or a metal silicide film as the metal compound film **14.**

Assume that a metal oxide film is used as the metal compound film **14.** Specifically, when the upper surface of the second insulation film **6** is a silicon oxide film, adhesion between the metal compound film **14** and the second insulation film 6 can be further increased. Accordingly, a highly reliable semiconductor device including a multi-layer interconnect with excellent adhesion can be achieved.

Assume that a metal nitride film is used as the metal compound film **14.** Specifically, when the upper surface of the second insulation film **6** is a silicon nitride film, adhesion between the metal compound film **14** and the second insulation film **6** can be increased further increased. Accordingly, a highly reliable semiconductor device including a multi-layer interconnect with excellent adhesion can be achieved.

Assume that a metal carbide film is used as the metal compound film **14.** Specifically, when the upper surface of the second insulation film **6** is a silicon carbide film or an organic film, adhesion between the metal compound film **14** and the second insulation film **6** can be further increased. Accordingly, a highly reliable semiconductor device including a multi-layer interconnect with excellent adhesion can be achieved.

Assume that a metal silicide film is used as the metal compound film **14.** Specifically, when the upper surface of the second insulation film **6** is an insulation film containing silicon, adhesion between the metal compound film **14** and the second insulation film **6** can be further increased. Accordingly, a highly reliable semiconductor device including a multi-layer interconnect with excellent adhesion can be achieved.

In the above-described manner, excellent adhesion can be achieved in an interface between any adjacent two of the second insulation film 6, the metal compound film **14,** the fusion layer **15,** the metal film **16** and the second copper interconnect **10.** Therefore, a semiconductor device having excellent adhesion as a whole can be achieved.

As has been described, according to the third embodiment of the present invention, a highly reliable semiconductor device including a multi-layer interconnect with a low resistance and excellent adhesion can be fabricated.

In this embodiment, the case where a dual damascene structure is adopted has been described. However, needless to say, even when a single damascene structure is adopted, the same effects as those in the case of adoption of a dual damascene structure can be achieved. When a single damascene structure is adopted, an interconnect and a via plug are formed in separate steps. In such a case, the interconnect and the via plug are included in a buried interconnect, i.e., the second copper interconnect **10** of this embodiment.

Moreover, in this embodiment, the case where copper or a copper alloy is used as a material of the buried interconnect, i.e., the second copper interconnect **10** has been described. In this embodiment, it is more preferable that a metal such as Ag, Au and Pt having a lower resistance than that of copper, or an alloy of the metal is used as a material of the buried interconnect.

### <Modified Example>

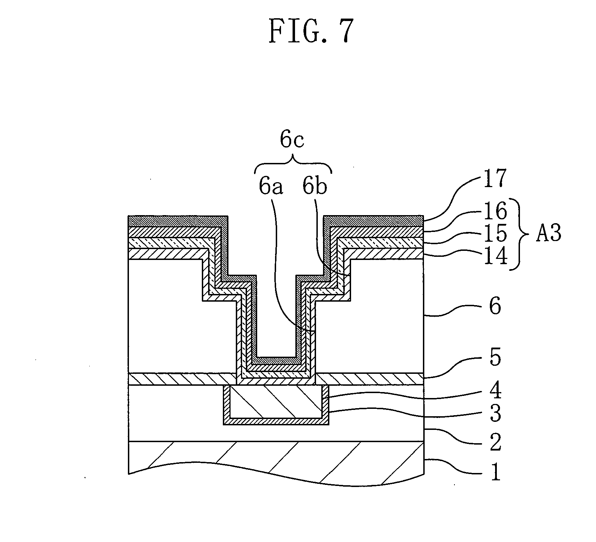

Hereinafter, a method for fabricating a semiconductor device according to a modified embodiment of the third embodiment of the present invention will be described with reference to FIG. 7, in addition to FIGS. **5(a)** and **5(b)** and FIGS. **6(a)** and **6(b)** which have been described.

FIG. 7 is a cross-sectional view of relevant part of a semiconductor device according to the modified example of third embodiment of the present invention illustrating respective steps for fabricating the semiconductor device.

In the method for fabricating a semiconductor device according to the modified example of third embodiment of the present invention, a metal compound film **14** is formed on a second insulation film **6** so as to cover surfaces of a recess portion **6c** in the manner described in FIGS. **5(a)** and **5(b).**

Next, as shown in FIG. 7, as in the manner described in FIG. **6(a),** a metal film **16** is formed on the metal compound film **14,** thereby forming a fusion layer **15.** Thus, a second barrier metal film **A3** including the metal compound film **14,** the fusion layer **15** and the metal film **16** is obtained. Furthermore, in this modified example, a copper seed layer **17** is formed on the metal film **16.** This formation of the copper seed layer 17 is a feature of this modified example.

Next, a copper film is formed on the copper seed layer **17** by electroplating so as to fill the recess portion **6c.** Thereafter, CMP is performed in the manner described in FIG. **6(b)** to form a second copper interconnect **10.** Thus, a copper damascene interconnect structure of FIG. **6(b)** can be achieved.

In the above-described manner, this modified example includes the step of forming the seed layer **17** between the step of forming the metal film 16 and the step of forming the second copper interconnect **10** in a series of fabrication process step shown in FIGS. **5(a)** and **5(b)** and FIGS. **6(a)** and **6(b).** In this point, the modified example is different from a series of fabrication process steps shown in FIGS. **5(a)** and **5(b)** and FIGS. **6(a)** and **6(b)** which have been described. Except for this point, the fabrication method of the modified example is the same as the method described in FIGS. **5(a)** and **5(b)** and FIGS. **6(a)** and **6(b).**

As has been described, since this modified example includes the step of forming a copper seed layer **17,** according to the modified example, more stable copper electroplating can be performed. Specifically, for example, even if part or the entire of the surface of the metal film **16** is oxidized, according to this modified example, more stable copper electroplating is allowed.

Therefore, according to this modified example, a highly reliable semiconductor device including a multi-layer interconnect with a low resistance and excellent adhesion can be more stably fabricated.

Note that when some other material than copper is used as a material for a buried interconnect, a material for a seed layer according to the material may be appropriately selected.

### INDUSTRIAL APPLICABILITY

As has been described, the present invention is useful to a semiconductor device including a barrier metal film with a low resistance and excellent adhesion and a method for fabricating the semiconductor device.

## Claims

1. A semiconductor device comprising:
an insulation film formed on a substrate;
a buried interconnect formed in the insulation film; and
a barrier metal film formed between the insulation film and the buried interconnect, wherein the barrier metal film is formed of a lamination film of a metal compound film and a metal film which does not loose its conductivity when being oxidized, and
wherein a fusion layer obtained through fusion of the metal compound film and the metal film with each other is present in the vicinity of an interface between the metal compound film and the metal film.

2. The semiconductor device of claim 1, wherein a metal forming the metal compound film and a metal forming the metal film are different elements from each other.

3. The semiconductor device of claim 1, wherein a metal forming the metal compound film and a metal forming the metal film are the same element.

4. The semiconductor device of claim 1, wherein the fusion layer includes at least several atomic layers.

5. The semiconductor device of claim 1, wherein the metal compound film is formed so as to be jointed with the insulation film, and
wherein the metal film is formed on the metal compound film.

6. The semiconductor device of claim 1, wherein a metal forming the metal compound film is a refractory metal.

7. The semiconductor device of claim 1, wherein the metal compound film has conductivity.

8. The semiconductor device of claim 1, wherein the metal compound film is formed of a metal oxide film.

9. The semiconductor device of claim 1, wherein the metal compound film is formed of a metal nitride film.

10. The semiconductor device of claim 1, wherein the metal compound film is formed of a metal carbide film.

11. The semiconductor device of claim 1, wherein the metal compound film is formed of a metal silicide film.

12. The semiconductor device of claim 1, wherein the buried interconnect is formed of copper or a copper alloy.

13. A method for fabricating a semiconductor device, comprising the steps of:
forming a recess portion in an insulation film provided on a substrate;
forming a barrier metal film so that the barrier metal film covers surfaces of the recess portion; and
forming a buried interconnect on the barrier metal film so that the recess portion is filled,
wherein the step of forming a barrier metal film includes the step of forming a metal compound film so that the metal compound film covers surfaces of the recess portion and then forming on the metal compound film by physical vapor deposition a metal film which does not loose its conductivity when being oxidized.

14. The method of claim 13, further comprising, between the step of forming a barrier metal film and the step of forming a buried interconnect, the step of forming a seed layer on the barrier metal film, and
wherein in the step of forming a buried interconnect, the buried interconnect is formed on the seed layer so that the buried interconnect fills the recess portion.

15. The method of claim 13, wherein a metal forming the metal compound film and a metal forming the metal film are different elements from each other.

16. The method of claim 13, wherein a metal forming the metal compound film and a metal forming the metal film are the same element.

17. The method of claim 13, wherein a fusion layer obtained through fusion of the metal compound film and the metal film with each other is formed in the vicinity of an interface between the metal compound film and the metal film, and
wherein the fusion layer includes at least several atomic layers.

18. The method of claim 13, wherein a metal forming the metal compound film is a refractory metal.

19. The method of claim 13, wherein the metal compound film has conductivity.

20. The method of claim 13, wherein the metal compound film is formed of a metal oxide film.

21. The method of claim 13, wherein the metal compound film is formed of a metal nitride film.

22. The method of claim 13, wherein the metal compound film is formed of a metal carbide film.

23. The method of claim 13, wherein the metal compound film is formed of a metal silicide film.

24. The method of claim 13, wherein the buried interconnect is formed of copper or a copper alloy.
